# EUROPÄISCHE PATENTSCHRIFT

(11) **EP 4 004 961 B1**
(45) Veröffentlichungstag und Bekanntmachung des Hinweises auf die Patenterteilung: **28.01.2026**
(21) Anmeldenummer: 20750634.6
(22) Anmeldetag: 30.07.2020
(51) Int. Cl.: H01J 37/04, H01J 37/317, G21K 1/10, H01L 21/265

(54) **VORRICHTUNG ZUR IMPLANTATION VON IONEN IN EIN ALS WAFER AUSGEBILDETES SUBSTRAT MIT EINEM ENERGIEFILTER**
DEVICE FOR THE IMPLANTATION OF IONS INTO A SUBSTRATE CONFIGURED AS A WAFER, THE DEVICE INCLUDING AN ENERGY FILTER
DISPOSITIF AVEC FILTRE D'ÉNERGIE POUR L'IMPLANTATION D'IONS DANS UN SUBSTRAT CONFIGURÉ COMME WAFER

(30) Priorität: 31.07.2019 DE 102019120623
(43) Veröffentlichungstag der Anmeldung: 01.06.2022
(73) Patentinhaber: mi2-factory GmbH, 07745 Jena (DE)
(72) Erfinder: CSATO, Constantin, 95236 Stammbach (DE); KRIPPENDORF, Florian, 07743 Jena (DE)
(74) Vertreter: Wächter, Jochen
(86) Internationale Anmeldenummer: PCT/EP2020/071559
(87) Internationale Veröffentlichungsnummer: WO 2021/019038

(56) Entgegenhaltungen:
- DE-A1- 102016 106 119
- DE-A1- 4 338 162
- DE-B3- 102005 019 250
- SATOSHI IWAMOTO ET AL: "Semiconductor Three-Dimensional Photonic Crystals with Novel Layer-by-Layer Structures", PHOTONICS, vol. 3, no. 2, 1 June 2016 (2016-06-01), pages 34, XP055739078, DOI: 10.3390/photonics3020034
- MINGHAO QI ET AL: "Fabrication of three-dimensional photonic crystals with midgap wavelength at 1.55 /spl mu/m", QUANTUM ELECTRONICS AND LASER SCIENCE, 2003. QELS. POSTCONFERENCE DIGE ST JUNE 1-6, 2003, PISCATAWAY, NJ, USA,IEEE, 6 June 2003 (2003-06-06), pages 2pp, XP032414997, ISBN: 978-1-55752-749-3, DOI: 10.1109/QELS.2003.238455
- J. BRAVO-ABAD ET AL: "Enabling single-mode behavior over large areas with photonic Dirac cones", PROCEEDINGS OF THE NATIONAL ACADEMY OF SCIENCES, vol. 109, no. 25, 4 June 2012 (2012-06-04), pages 9761 - 9765, XP055740128, ISSN: 0027-8424, DOI: 10.1073/pnas.1207335109
- CSATO CONSTANTIN ET AL: "Energy filter for tailoring depth profiles in semiconductor doping application", NUCLEAR INSTRUMENTS & METHODS IN PHYSICS RESEARCH. SECTION B: BEAM INTERACTIONS WITH MATERIALS AND ATOMS, vol. 365, 31 July 2015 (2015-07-31), pages 182 - 186, XP029313812, ISSN: 0168-583X, DOI: 10.1016/J.NIMB.2015.07.102
- TOKE PRINTZ RINGB K ET AL: "Modulation power of porous materials and usage as ripple filter in particle therapy", PHYSICS IN MEDICINE AND BIOLOGY, INSTITUTE OF PHYSICS PUBLISHING, BRISTOL GB, vol. 62, no. 7, 15 March 2017 (2017-03-15), pages 2892 - 2909, XP020315175, ISSN: 0031-9155, [retrieved on 20170315], DOI: 10.1088/1361-6560/AA5C28
- "Abstracts DEGRO 2018", STRAHLENTHERAPIE UND ONKOLOGIE, URBAN UND VOGEL, MUENCHEN, DE, vol. 194, no. 1, 17 May 2018 (2018-05-17), pages 1 - 222, XP036729610, ISSN: 0179-7158, [retrieved on 20180517], DOI: 10.1007/S00066-018-1301-7

## Beschreibung

Die Erfindung betrifft eine Vorrichtung zur Implantation von Ionen in ein als Wafer ausgebildetes Substrat mit einem Energiefilter.

Derartige mikrostrukturierte Energiefilter werden vom Ionenstrahl vor Erreichen des Substrats durchstrahlt und dienen dazu, ein durch die Implantation hervorgerufenes Dotierstofftiefenprofil im Substrat einzustellen.

Ein derartiger Energiefilter ist beispielsweise in DE 10 2016 106 119 A1 beschrieben. Er ist üblicherweise als mikrostrukturierte Membran ausgebildet, die auf einer Außenfläche mit einem vorbestimmten geometrischen Profil versehen ist. Der Energiefilter kann auch aus mehreren Schichten bestehen.

Problematisch an solchen Energiefiltern ist unter anderem die mechanische Anfälligkeit der Membran oder die Notwendigkeit einer relativ dicken Stützschicht, die wiederum aufgrund ihrer Abbremseigenschaften eine oftmals ungewünschte Erhöhung der Primärionenenergie notwendig macht.

Der vorliegenden Erfindung liegt die Aufgabe zugrunde, einen Energiefilter zu schaffen, der eine erhöhte mechanische Stabilität besitzt und somit großflächig ausgebildet werden kann, der auch für niederenergetische Primärionenenergien verwendbar ist und eine uniforme hochpräzise Dotierstoff-Tiefenverteilung im Substrat ermöglicht. Das Dokument TOKE PRINTZ RINGB K ET AL: "Modulation power of porous materials and usage as ripple filter in particle therapy",PHYSICS IN MEDICINE AND BIOLOGY, INSTITUTE OF PHYSICS PUBLISHING, BRISTOL GB, Bd. 62, Nr. 7, 15. März 2017 (2017-03-15), Seiten 2892-2909, XP020315175,ISSN: 0031-9155, DOI: 10.1088/1361-6560/AA5C28, offenbart poröse Materialien als sog. Ripple-Filter in der Teilchenstrahltherapie mit Ionen.

Diese Aufgabe wird durch die Merkmale des Anspruchs 1 gelöst.

Erfindungsgemäß ist der Energiefilter in der Vorrichtung zur Implantation von Ionen in ein als Wafer ausgebildetes

Substrat mikrostrukturiert zur Einstellung eines durch die Implantation hervorgerufenen Do tierstofftiefenprofils und/oder Defekttiefenprofils im Substrat, und weist zwei oder mehr Schichten oder Schichtabschnitte auf, die in Höhenrichtung des Energiefilters hintereinander angeordnet sind. Der Energiefilter weist außerdem eine Mehrzahl von Hohlräumen auf, die jeweils zwischen mindestens zwei Schichten oder Schichtabschnitten angeordnet sind, wobei Zwischenwände die Hohlräume begrenzen und die mindestens zwei Schichten oder Schichtabschnitte miteinander verbinden.

Auf diese Weise wird ein Energiefilter geschaffen, der mit der für ein Zieldotierprofil minimal notwendigen Primärionenenergie auskommt und eine verbesserte mechanische Stabilität aufweist. Aus letzterem Grund kann der Energiefilter auch großflächiger als üblich gestaltet und somit für größere Substratdurchmesser verwendet werden.

Vorzugsweise sind zwei den Energiefilter nach außen begrenzende Schichten im Wesentlichen durchgängig ausgebildet sind. Damit wird eine Kontaminierung des Substrats durch im Energiefilter abgesputtertes Material großflächig verhindert.

Vorzugsweise sind zwei den Energiefilter nach außen begrenzende Schichten im Wesentlichen planar ausgebildet sind. Während sich in einer profilierten Oberfläche leicht Staub und Partikel ansammeln, ist die ebene Oberfläche relativ resistent gegenüber Verschmutzung.

In bevorzugter Ausgestaltung beträgt der Abstand zwischen zwei aufeinanderfolgenden Schichten oder Schichtabschnitten zwischen 100 nm und 5 mm, bevorzugt zwischen 200 nm und 50 µm.

In bevorzugter Ausgestaltung beträgt die Dicke einer Schicht oder eines Schichtabschnitts zwischen 50 nm und 5 µm, bevorzugt zwischen 100 nm und 3 µm.

In bevorzugter Ausgestaltung beträgt die Dicke einer Zwischenwand zwischen 0,5 und 500 µm, bevorzugt zwischen 2 und 100 µm.

Vorzugsweise weist der Energiefilter eine Vielzahl von Einzelzellen auf, die jeweils einen Hohlraum und mindestens zwei Zwischenwände aufweisen. Auf diese Weise lässt sich ein gewünschtes Dotierprofil besonders zielgenau einstellen.

Vorzugsweise sind die Einzelzellen wabenartig angeordnet sind.

Vorzugsweise liegt bei einer Mehrzahl von Einzelzellen das Verhältnis einer maximalen lateralen Ausdehnung der Einzelzelle in einer Längen- und/oder Breitenrichtung des Energiefilters zu einer Ausdehnung der Zwischenwände der Einzelzelle in Höhenrichtung des Energiefilters zwischen 1:2 und 1:12, mehr bevorzugt zwischen 1:4 und 1:10. Auf diese Weise wirken die Einzelzellen gleichzeitig als integrierte Kollimatorstruktur.

Vorzugsweise weist der Energiefilter eine Mehrzahl von nebeneinander angeordneten und sich über die gesamte Höhe des Energiefilters erstreckenden säulenförmigen Strukturelementen auf, wobei eine Mehrzahl der säulenförmigen Strukturelemente jeweils eine Mehrzahl von in Höhenrichtung des Energiefilters hintereinander angeordneten Schichtabschnitten umfasst.

Besonders bevorzugt weist eine Mehrzahl der säulenförmigen Strukturelemente jeweils eine Vielzahl von in Höhenrichtung des Energiefilters hintereinander angeordneten Einzelzellen auf.

Grundsätzlich haben die Strukturelemente, welche eine definierte diskrete transmittierte Ionenenergie definieren können, laterale Abmessungen zwischen 500 nm und 500 µm.

Die laterale Ausdehnung einer Strukturelementeanordnung, welche für ein gegebenes Zieltiefenprofil alle benötigten energiemodulierenden Strukturelemente enthält, liegt in seinen lateralen Abmessungen zwischen 5 µm und 30 mm.

Der Energiefilter besitzt vorzugsweise eine Dicke von zwischen 3 µm und 5 cm, mehr bevorzugt zwischen 5 µm und 300 µm und besonders bevorzugt zwischen 50 µm und 200 µm.

Der Energiefilter besitzt vorzugsweise eine Länge und Breite von zwischen 2 cm und 50 cm.

Der Energiefilter kann auch eine Mehrzahl von gefüllten Zellen aufweisen. Dies dient der Erhöhung des Abbremsvermögens.

Eine Mehrzahl der Zwischenwände kann senkrecht zu den Schichten oder Schichtabschnitten angeordnet sein.

Eine Mehrzahl der Zwischenwände kann auch schräg zu den Schichten oder Schichtabschnitten angeordnet sein. In diesem Fall dienen auch die Zwischenwände zur Abbremsung, ebenso wie die Schichten oder Schichtabschnitte.

### Kurze Beschreibung der Figuren

- Fig. 1: ist eine schematische Ansicht des Wirkprinzips der Ionenimplantation in ein Substrat unter Verwendung eines Energiefilters;
- Fig. 2: ist eine schematische Darstellung der Wirkweise eines Energiefilters;
- Fig. 3: ist eine schematische Darstellung verschiedener Dotierprofile, die mittels verschieden strukturierter Energiefilter erzeugt werden können;
- Fig. 4: ist eine schematische Querschnittsansicht eines Ausschnitts des Energiefilters;
- Fig. 5: ist eine schematische Längsschnittsansicht eines Ausschnitts des Energiefilters;
- Fig. 6: ist eine schematische Längsschnittsansicht eines Ausschnitts einer alternativen Form des Energiefilters;
- Fig. 7: ist eine schematische Querschnittsansicht eines Ausschnitts einer alternativen Form des Energiefilters;
- Fig. 8: ist eine schematische Querschnittsansicht eines Ausschnitts einer alternativen Form des Energiefilters; und
- Fig. 9: ist eine schematische Querschnittsansicht eines Ausschnitts einer alternativen Form des Energiefilters.

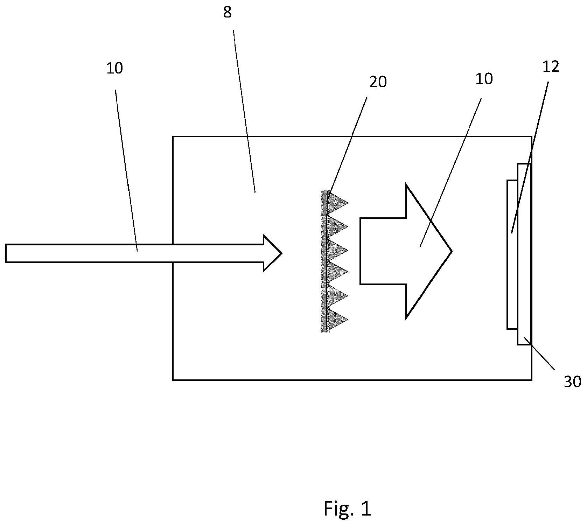

In Fig. 1 ist das Wirkprinzip der Ionenimplantation in ein Substrat 12 unter Verwendung eines Energiefilters 20 schematisch dargestellt. Der in Fig. 1 gezeigte Aufbau zur Ionenimplantation in ein Substrat 12 zeigt eine Bestrahlungskammer 8, in der üblicherweise ein Hochvakuum vorliegt. In der Bestrahlungskammer 8 ist das zu dotierende Substrat 12 in einer Substrathalterung 30 aufgenommen.

Das Material des Substrats 12 ist vorzugsweise Siliziumkarbid (SiC). Es kommen aber auch andere Materialien wie Silizium, Galliumarsenid, Cadmiumtellurid, Zinkselenid, Galliumnitrid, Kunststoffe, Glas oder Isolatoren (Diamant) etc. in Frage. Die Substrate 12 sind als Wafer ausgebildet. Die Substrate 12 besitzen üblicherweise eine Dicke von 4 µm bis 5 mm.

Ein Ionenstrahl 10 wird mittels eines Teilchenbeschleunigers (nicht dargestellt) erzeugt und in die Bestrahlungskammer 8 geleitet. Dort wird die Energie des Ionenstrahls 10 durch einen Energiefilter 20 aufgespreizt und er trifft auf das zu bestrahlende Substrat 12. Alternativ kann der Energiefilter 20 in einer separaten, mit Ventilen verschließbaren Vakuumkammer innerhalb der Bestrahlungskammer 8 oder unmittelbar angrenzend an die Bestrahlungskammer 8 angeordnet sein.

Die Substrathalterung 30 muss nicht stationär sein, sondern kann optional mit einer Einrichtung zum Verschieben des Substrates 12 in x-y (in der Ebene senkrecht zur Blattebene) versehen sein. Als Substrathalterung 30 kommt außerdem auch ein Waferrad in Betracht, auf welchem die zu implantierenden Substrate 12 fixiert werden und das sich während der Implantation dreht. Auch eine Verschiebung der Substrathalterung 30 in Strahlrichtung (z-Richtung) kann möglich sein. Weiterhin kann die Substrathalterung 30 optional mit einer Kühlung versehen sein.

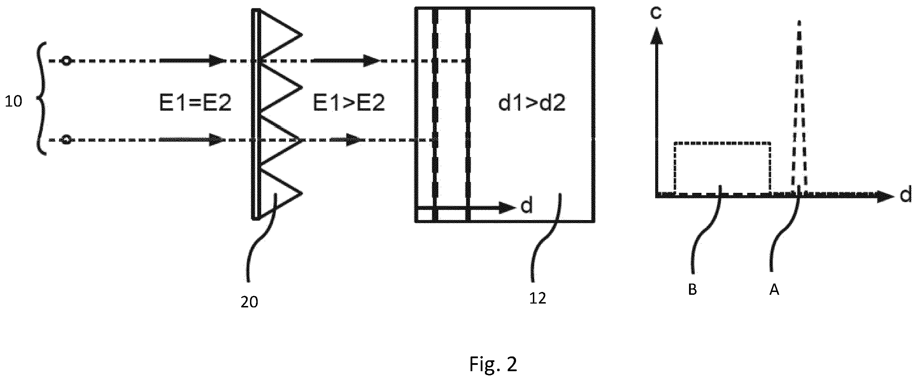

Das Grundprinzip des Energiefilters 20 ist in Fig. 2 dargestellt. Der monoenergetische lonenstrahl 10 wird beim Durchtritt durch den mikrostrukturierten Energiefilter 20 abhängig vom Eintrittsort in seiner Energie modifiziert. Die resultierende Energieverteilung der Ionen des Ionenstrahls 10 führt zu einer Modifikation des Tiefenprofils des implantierten Stoffes in der Matrix des Substrats 12. E1 bezeichnet die Energie eines ersten Ions, E2 bezeichnet die Energie eines zweiten Ions, c bezeichnet die Dotierkonzentration und d bezeichnet die Tiefe im Substrat 12. Im Diagramm rechts ist die übliche Gaußverteilung mit Bezugszeichen A gekennzeichnet, die ohne Einsatz eines Energiefilters 20 entsteht. Hingegen ist beispielhaft mit Bezugszeichen B eine Rechteckverteilung skizziert, die bei Einsatz eines Energiefilters 20 erzielt werden kann.

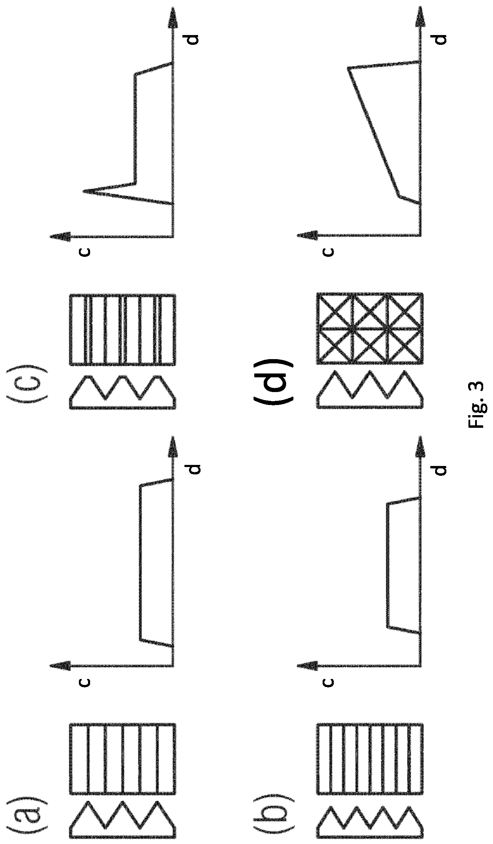

Die in Fig. 3 gezeigten Layouts bzw. dreidimensionalen Strukturen von Energiefiltern 20 zeigen die prinzipiellen Möglichkeiten, mittels Energiefilter 20 eine Vielzahl von Dotierstofftiefenprofilen oder Defekttiefenprofilen zu erzeugen. c bezeichnet wiederum die Dotierkonzentration und d bezeichnet wiederum die Tiefe im Substrat 12. Die Filterstrukturprofile können im Prinzip miteinander kombiniert werden, um neue Filterstrukturprofile und somit neue Dotierstofftiefenprofile oder Defekttiefenprofile zu erhalten.

Die Energiefilter 20 können in einem Filterrahmen (nicht dargestellt) gehalten sein. Der Filterrahmen kann austauschbar in einer Filterhalterung (nicht dargestellt) aufgenommen sein.

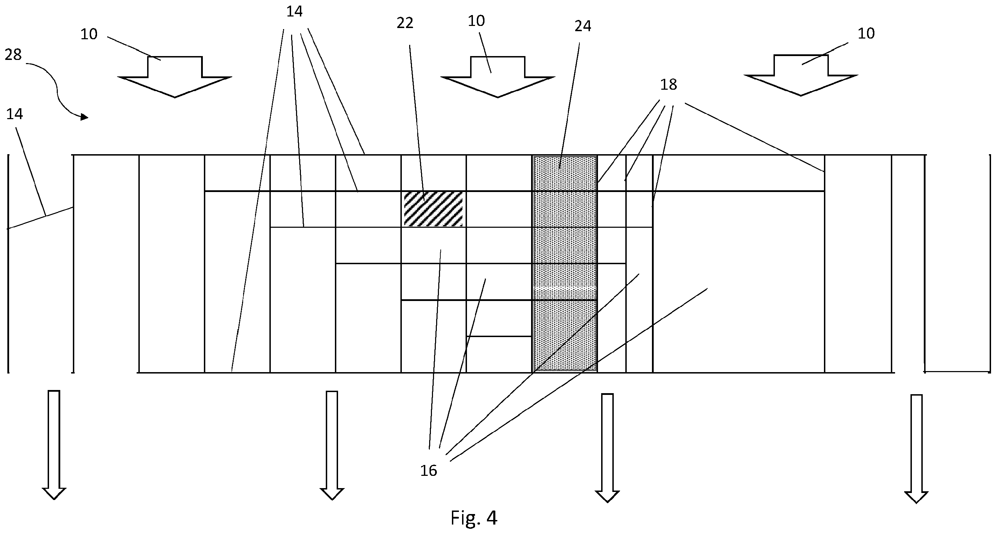

Fig. 4 zeigt einen Ausschnitt einer Ausführungsform des Energiefilters 20 für die erfindungsgemäße Vorrichtung im schematischen Querschnitt. Der dargestellte Ausschnitt des Energiefilters 20 ist lediglich ein kleiner Ausschnitt der Gesamtstruktur.

Der Energiefilter 20 ist in Höhenrichtung, die vorzugsweise der durch die Pfeile skizzierten Strahlrichtung des Ionenstrahls 10 entspricht, mehrlagig aufgebaut. Hierzu weist der Energiefilter 20 eine Mehrzahl von Schichten oder Schichtabschnitten 14 auf, die in Höhenrichtung des Energiefilters 20 hintereinander angeordnet sind. Die Anzahl der Schichten oder Schichtabschnitte 14 liegt zwischen 2 und 100, bevorzugt zwischen 10 und 30.

Es ist möglich, dass bestimmte Schichten 14 sich über die komplette Breite und/oder Länge des Energiefilters 20 erstrecken, insbesondere die beiden den Energiefilter 20 nach außen begrenzenden Schichten 14 (in Fig. 4 die oberste und unterste Schicht 14). Ebenso ist es im Rahmen der Erfindung bevorzugt, dass bestimmte Schichten oder Schichtabschnitte 14 sich lediglich über Teilbereiche des Energiefilters 20 erstrecken. Diese Schichten oder Schichtabschnitte 14 sind in erster Linie für die Energiemodulation des Ionenstrahls 10 im Energiefilter 20 verantwortlich.

Die energiemodifizierenden Schichten oder Schichtabschnitte 14 sind bevorzugt parallel zueinander angeordnet. Es kann aber auch vorkommen, dass eine energiemodifizierende Schicht 14 nicht parallel zu anderen Schichten 14 ausgerichtet ist (siehe links in Fig. 4).

Jede Schicht oder jeder Schichtabschnitt 14 ist vorzugsweise als Membran ausgebildet. Das Material der Schichten oder Schichtabschnitte 14 kann identisch oder unterschiedlich sein. Als Materialien für die Schichten oder die Schichtabschnitte 14 kommen insbesondere Silizium, Siliziumkarbid oder Kohlenstoff in Frage. Auch andere Materialien sind denkbar. Die Schichten oder Schichtabschnitte 14 sind in Höhenrichtung des Energiefilters 20 üblicherweise voneinander beabstandet, es ist aber auch möglich, dass zwei oder mehr Schichten oder Schichtabschnitte 14 unmittelbar aneinander angrenzen.

Die resultierende Energieverteilung eines monoenergetischen Ionenstrahls 10 hinter dem Energiefilter 20 ist zusammengesetzt aus diskreten Energien, die den jeweils entstehenden Summenenergieverlusten im Energiefilter 20 entsprechen.

Wenn zwei in Höhenrichtung des Energiefilters 20 aufeinanderfolgende Schichten oder Schichtabschnitte 14 voneinander beabstandet angeordnet sind, wird zwischen diesen Schichten oder Schichtabschnitten 14 ein Hohlraum 16 gebildet. Erfindungsgemäß weist ein Energiefilter 20 eine Mehrzahl derartiger Hohlräume 16 auf. Zwischenwände 18 begrenzen die Hohlräume 16 und verbinden jeweils mindestens zwei Schichten oder Schichtabschnitte 14 miteinander. Die Zwischenwände 18 verlaufen in dem in Fig. 4 dargestellten Ausführungsbeispiel parallel zur Höhenrichtung des Energiefilters 20, d.h. in Strahlrichtung des Ionenstrahls 10. Es kann vorteilhaft sein, wenn diese lateral begrenzenden Zwischenwände 18 zwischen den einzelnen Hohlräumen 16 des Energiefilters 20 bezüglich ihrer Stärke so beschaffen sind, dass Ionen nicht zu benachbarten Hohlräumen 16 hindurchtreten können.

Anders als bei herkömmlichen Energiefiltern sind beide den Energiefilter 20 nach außen begrenzenden Schichten 14 im Wesentlichen planar ausgebildet. In diesem Fall muss die innere Struktur des Energiefilters 20 alleine für die gewünschte Energiemodulation sorgen. Es ist aber auch möglich, dass zumindest eine der beiden den Energiefilter 20 nach außen begrenzenden Schichten 14 teilweise oder vollständig profiliert ist.

Wenn man die Struktur des Energiefilters 20 für die erfindungsgemäße Vorrichtung mit anderen Worten beschreiben möchte, weist der Energiefilter 20 eine Vielzahl von Einzelzellen 22 auf, die jeweils einen Hohlraum 16 und mindestens zwei Zwischenwände 18 aufweisen. In Fig. 4 ist ein Beispiel einer Einzelzelle 22 schraffiert dargestellt. Wenn man den Energiefilter 20 aus einer mehr funktionalen Blickrichtung beschreiben möchte, so besteht er aus einer Vielzahl von nebeneinander angeordneten und sich über die gesamte Höhe des Energiefilters 20 erstreckenden säulenförmigen Strukturelementen 24. Ein Beispiel eines säulenförmigen Strukturelements 24 ist in Fig. 4 gepunktet dargestellt. Die meisten säulenförmigen Strukturelemente 24 umfassen jeweils eine Mehrzahl von in Höhenrichtung des Energiefilters 20 hintereinander angeordneten Schichtabschnitten 14. Die Anzahl, das Material und die Dicke der im jeweiligen säulenförmigen Strukturelement 24 vom Ionenstrahl 10 zu passierenden Schichtabschnitte 14 definieren den Energieverlust des Ionenstrahls in diesem Mikrogebiet des Energiefilters 20.

Mit anderen Worten werden die meisten, wenn nicht alle säulenförmigen Strukturelemente 24 jeweils eine Mehrzahl von Hohlräumen 16 und eine Mehrzahl von Zwischenwänden 18 umfassen. Ebenso wird in der Regel eine Mehrzahl der säulenförmigen Strukturelemente 24 jeweils eine Vielzahl von in Höhenrichtung des Energiefilters 20 hintereinander angeordneten Einzelzellen 22 aufweisen.

Insgesamt sind der Ausgestaltung des Energiefilters 20 in vielerlei Hinsicht kaum Grenzen gesetzt. Wie bereits oben erwähnt können sich die Schichten oder Schichtabschnitte 14 über die gesamte Länge und/oder Breite des Energiefilters 20 erstrecken oder über größere oder kleinere Teilbereiche davon. Ebenso können sich die Zwischenwände 18 in Höhenrichtung des Energiefilters 20 über die gesamte Höhe des Energiefilters 20 erstrecken oder auch nur über Teilbereiche davon. Daraus ergibt sich ein Muster aus Einzelzellen 22, die jeweils einem einzelnen säulenartigen Strukturelement 24 zuzuordnen sind, oder aber auch übergreifend über zwei oder mehrere säulenartige Strukturelemente 24 erstreckt sein können.

Auf diese Weise wird es ermöglicht, innerhalb des Energiefilters durch geeignete Strukturierung der Schichten oder Schichtabschnitte 14 sowie der Zwischenwände 18 eine innere Profilstruktur des Energiefilters 20 zu bilden, welche die gewünschte Energiemodulation des Ionenstrahls 10 liefert.

In der in Fig. 4 dargestellten Ausführungsform ergibt sich im Wesentlichen ein Stufenprofil der Schichten oder Schichtabschnitte 14 mit einem im Wesentlichen dreieckigen Aufbau und einer Spitze im Strukturelement links neben dem gepunktet skizzierten Strukturelement 24. In diesem mittleren Strukturelement 24 muss der Ionenstrahl 10 durch die meisten Schichten oder Schichtabschnitte 14 in Höhenrichtung des Energiefilters 20 hindurchtreten und verliert somit die meiste Energie. In den Strukturelementen 24, die weiter zur Seite hin angeordnet sind, wird die Anzahl der jeweils vom Ionenstrahl 10 zu passierenden Schichten oder Schichtabschnitte 14 immer geringer. Derartige Dreieckstrukturen oder andere regelmäßige geometrische Strukturen können durch geeignete Wahl und Anordnung der Schichten und Schichtabschnitte 14 auf nahezu beliebige Weise erzeugt werden.

Die in Fig. 4 dargestellten Strukturelemente 24 bilden gemeinsam eine Strukturelementeanordnung 28. Solche Strukturelementeanordnungen 28 können in beliebiger Weise periodisch mehrfach nebeneinander angeordnet werden, beispielsweise um ein großflächiges Substrat 12 zu bestrahlen, und bilden gemeinsam den Energiefilter 20.

Die Gestaltung beliebiger Tiefenprofile kann dadurch erreicht werden, dass einzelne Strukturelemente 24 unterschiedliche Ausdehnung und damit unterschiedliche Flächenausdehnung in Relation zur Gesamtfläche der Strukturelementeanordnung 28 einnehmen. Dadurch kann per Design die resultierende Ionenkonzentration der dieser Ionenenergie zugeordneten Eindringtiefe im Substrat 12 in beliebiger Form gestaltet werden.

Bei statischer Anwendung von Energiefiltern 20 (Substrat 12 und Energiefilter 20 werden nicht bewegt) ist es wichtig, die Ausdehnung einer Strukturelementeanordnung 28, welche das gesamte gewünschte Energiespektrum approximiert, in ihren lateralen Abmessungen so klein zu halten, dass eine lateral homogene Tiefenverteilung, aufgrund der Streuung durch den Energiefilter 20, auf jedem Flächenelement des Substrats 12 gewährleistet ist. Die maximal möglichen Abmessungen einer Strukturelementeanordnung 28 bei statischer Bestrahlung sind eine Funktion der Ionenenergie, der Ionenart und des Abstandes zwischen Energiefilter 20 und Substrat 12.

Wie oben bereits erwähnt und aus Fig. 4 ersichtlich, kann die Breite der säulenförmigen Strukturelemente 24 variieren. Ebenso kann jedes säulenförmige Strukturelement 24 nach außen hin von zwei begrenzenden Schichten oder Schichtabschnitten 14 abgedeckt sein oder kann, wie in den Randbereichen von Fig. 4 ersichtlich, auch nach einer Seite oder nach beiden Seiten hin offen sein.

Besonders wichtig ist es zu erwähnen, dass die dargestellte Querschnittsstruktur bzw. eine entsprechende, gewünschte Struktur ebenfalls in einer Richtung senkrecht zur dargestellten Richtung vorhanden ist, d.h. der Energiefilter 20 bildet ein dreidimensionales Objekt, das sowohl in Längen - als auch in Breitenrichtung mikrostrukturiert ist.

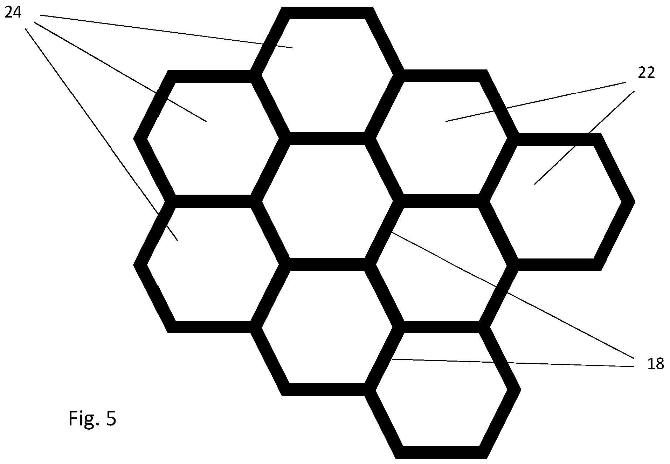

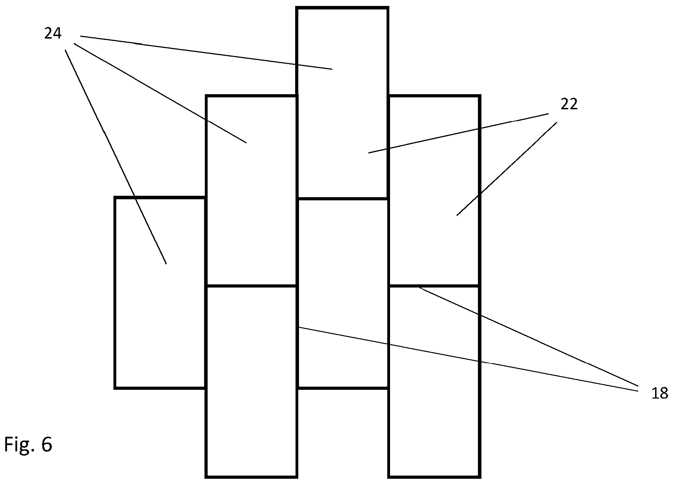

In Fig. 5 und 6 sind zwei beispielhafte Möglichkeiten der Anordnung von säulenförmigen Strukturelementen 24 bzw. von Einzelzellen 22 im Längsschnitt (betrachtet aus Richtung der den Ionenstrahl 10 skizzierenden Pfeile in Fig. 4) zu sehen. Bevorzugt ist eine Wabenform wie in Fig. 5 oder eine verschachtelte Form von im Schnitt rechteckigen Strukturelementen 24 wie in Fig. 6.

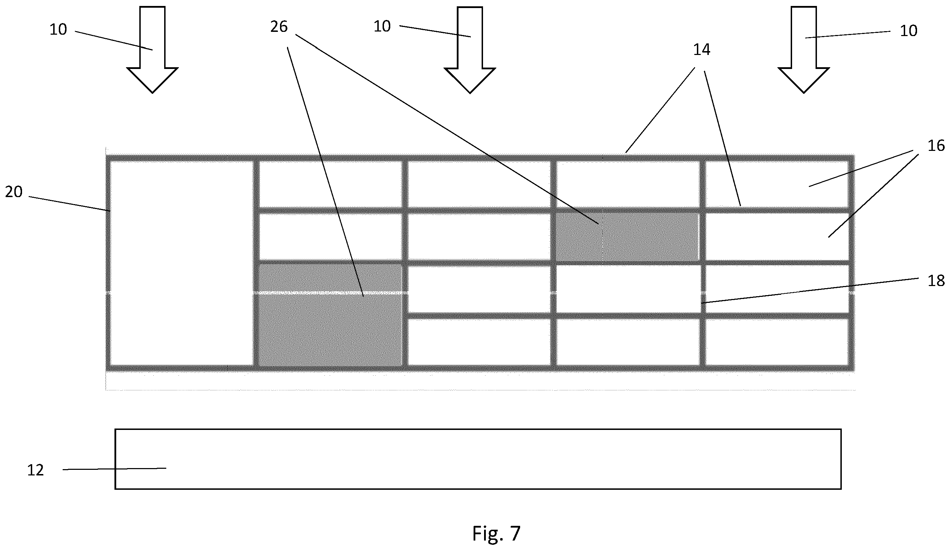

In Fig. 7 ist zudem gezeigt, dass ein Energiefilter 20 für die erfindungsgemäße Vorrichtung auch gefüllte Zellen 26 aufweisen kann, die in einem regelmäßigen oder unregelmäßigen Muster im Energiefilter 20 verteilt sein können. Damit kann ein stellenweise größeres Abbremsvermögen des Energiefilters 20 erreicht werden. Das Material der gefüllten Zellen kann beispielsweise Si, SiC, C oder Diamant sein, ebenso kommen geeignete Oxide und Nitride, beispielsweise SiO₂, oder Kunststoffe wie PMMA, sowie Keramiken oder Metalle in Frage.

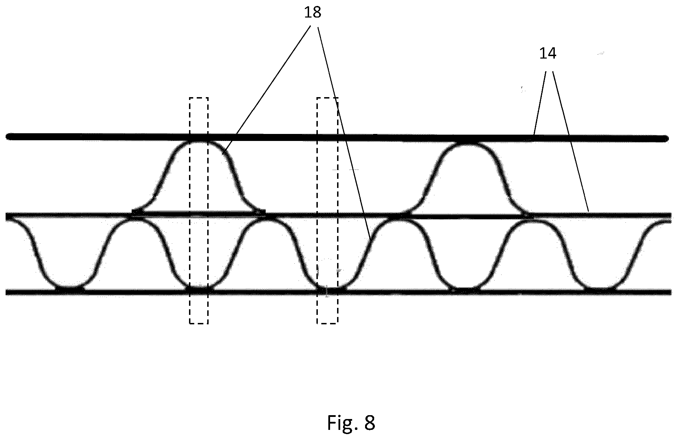

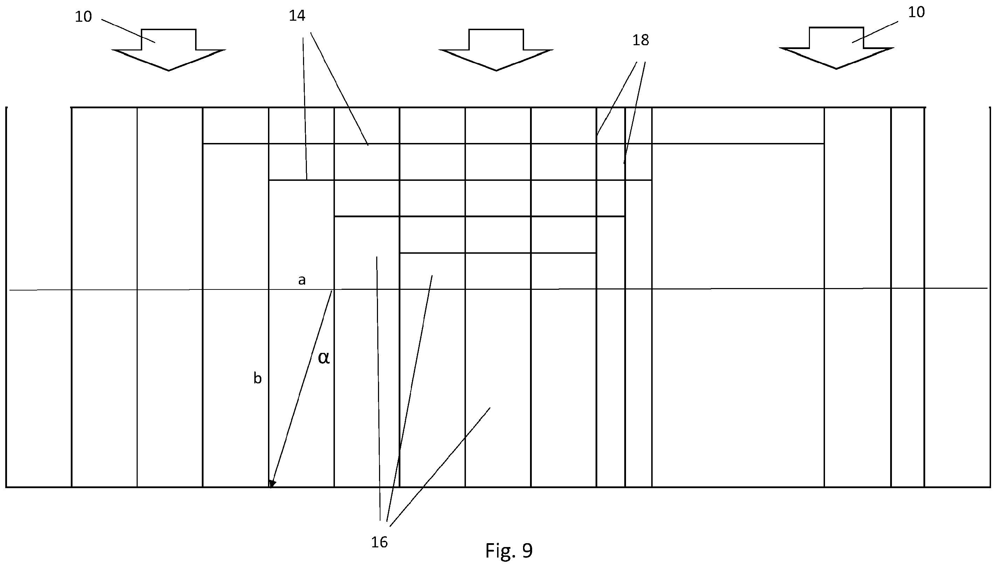

Wie aus Fig. 8 hervorgeht, ist es auch denkbar, dass die Zwischenwände 18 nicht in Höhenrichtung des Energiefilters 20 verlaufen, sondern schräg hierzu oder, wie in Fig. 9 dargestellt, in einem gekrümmten Verlauf zwischen den angrenzenden Schichten oder Schichtabschnitten 14. In diesen Fällen tragen auch die Zwischenwände 18 zur Abbremsung des Ionenstrahls 10 bei.

Dann existieren wiederum Bereiche des Energiefilters 20, in denen der Ionenstrahl 10 eine größere Anzahl von Schichten oder Schichtabschnitten 14 und Zwischenwänden 18 passieren muss (siehe den linken gestrichelt markierten Bereich, in dem der Ionenstrahl fünf Schichten/Schichtabschnitte/Zwischenwände passieren muss), und Bereiche, in denen der Ionenstrahl eine geringere Anzahl von Schichten oder Schichtabschnitten 14 und Zwischenwänden 18 passieren muss (siehe den rechten gestrichelt markierten Bereich, in dem der Ionenstrahl nur vier Schichten/Schichtabschnitte/Zwischenwände passieren muss).

Wie in Fig. 9 dargestellt, kann der Energiefilter 20 auch eine integrierte Kollimatorstruktur aufweisen.

Abhängig von der Primärenergie beim Eintritt von Ionen in eine energiemodulierende Schicht oder einen Schichtabschnitt 14 kommt es zu einer mehr oder weniger starken Streuung der Ionen an dieser Schicht oder diesem Schichtabschnitt 14 und somit zur Aufweitung der Winkelverteilung des austretenden Ionenstrahls im Vergleich zum einfallenden primären Ionenstrahl 10. Die Energieabhängigkeit erklärt sich daraus, dass der mikroskopische Abbremsmechanismus in Materie entweder über Anregung des Elektronensystems des Materials (elektronisches Abbremsen) oder über interatomare Stöße mit Atomen in den Schichten (nukleares Abbremsen) abläuft. Elektronisches Abbremsen hat nur eine geringe Streuwirkung und ist bei hohen Ionenenergien bevorzugt. Nukleares Abbremsen hat eine starke Streuwirkung und ist bei niedrigen Energien bevorzugt.

Für die Applikation energiegefilterter Ionen ist es häufig erwünscht, dass die durch den Energiefilter 20 transmittierten Ionen eine möglichst enge Winkelverteilung besitzen. Insbesondere für Anwendungen mit Maskierung ist die Winkelverteilung der implantierten Ionen von entscheidender Bedeutung.

Die Einzelzellen 22 im Energiefilter 20 sind so ausgestaltet, dass sie durch die Dimensionierung des Aspektverhältnisses (Verhältnis der maximalen Länge oder Breite zur Höhe) des Hohlraums 16 zwischen den energiemodifizierenden Schichten oder Schichtabschnitten 14 einen gewünschten Grad an fokussierender Wirkung erzielen. Die Unterscheidung zwischen fokussierenden und "einfachen" Einzelzellen 22 kann anhand deren Aspektverhältnis abgeschätzt werden:
Max. Einzelzellendurchmesser : Einzelzellenhöhe > 1:1, z.B. 5:1 → kein fokussierendes Element
Max. Einzelzellendurchmesser : Einzelzellenhöhe < 1:1, z.B. 1:5 → fokussierendes Element

Erfindungsgemäß ist es bevorzugt, wenn zumindest bei einer Mehrzahl von Einzelzellen 22 das Verhältnis der maximalen lateralen Ausdehnung a der Einzelzelle 22 in einer Längen- und/oder Breitenrichtung des Energiefilters 20 zu einer Ausdehnung b der Zwischenwände 18 der Einzelzelle 22 in Höhenrichtung des Energiefilters 20 zwischen 1:2 und 1:12, vorzugsweise zwischen 1:4 und 1:10 liegt. In diesem Fall findet eine relativ starke Fokussierung statt. Ein solches Aspektverhältnis liegt beispielsweise in der untersten Reihe von Einzelzellen 22 in Fig. 9 vor. In Fig. 9 ist der unterste Hohlraum 16 jedes Strukturelements 24, den die Ionen durchlaufen müssen, in seiner vertikalen Ausdehnung so groß, dass sich hieraus ein Maximalwinkel α der durchlaufenden Ionen ergibt. Dieser unterste Hohlraum 16 ist zudem bevorzugt durch eine energiemodulierende Schicht 14 abgeschlossen.

Ein solcher Energiefilter 20 kann somit auch als Abfolge von energiemodifizierenden Schichten oder Schichtabschnitten 14 und Fokussierelementen aufgefasst werden, oder er kann als integrierte Energiefilter- und Fokussiervorrichtung bezeichnet werden.

## Patentansprüche

1. Vorrichtung zur Implantation von Ionen in ein als Wafer ausgebildetes Substrat (12), mit
einem Energiefilter (20), der mikrostrukturiert ist zur Einstellung eines durch die Implantation hervorgerufenen Dotierstofftiefenprofils und/oder Defekttiefenprofils im Substrat (12), und
der zwei oder mehr Schichten oder Schichtabschnitte (14) aufweist, die in Höhenrichtung des Energiefilters (20) hintereinander angeordnet sind,
**dadurch gekennzeichnet, dass**
der Energiefilter (20) eine Mehrzahl von Hohlräumen (16) aufweist, die jeweils zwischen mindestens zwei Schichten oder Schichtabschnitten (14) angeordnet sind, wobei Zwischenwände (18) die Hohlräume (16) begrenzen und die mindestens zwei Schichten oder Schichtabschnitte (14) miteinander verbinden.

2. Vorrichtung nach Anspruch 1, **dadurch gekennzeichnet, dass** zwei den Energiefilter (20) nach außen begrenzende Schichten (14) im Wesentlichen durchgängig ausgebildet sind.

3. Vorrichtung nach Anspruch 1 oder 2, **dadurch gekennzeichnet, dass** zwei den Energiefilter (20) nach außen begrenzende Schichten (14) im Wesentlichen planar ausgebildet sind.

4. Vorrichtung nach einem der vorangehenden Ansprüche, **dadurch gekennzeichnet, dass** der Abstand zwischen zwei aufeinanderfolgenden Schichten oder Schichtabschnitten (14) zwischen 100 nm und 5 mm, bevorzugt zwischen 200 nm und 50 µm, beträgt.

5. Vorrichtung nach einem der vorangehenden Ansprüche, **dadurch gekennzeichnet, dass** die Dicke einer Schicht oder eines Schichtabschnitts (14) zwischen 50 nm und 5 µm, bevorzugt zwischen 100 nm und 3 µm, beträgt.

6. Vorrichtung nach einem der vorangehenden Ansprüche, **dadurch gekennzeichnet, dass** die Dicke einer Zwischenwand (18) zwischen 0,5 und 500 µm, bevorzugt zwischen 2 und 100 µm, beträgt.

7. Vorrichtung nach einem der vorangehenden Ansprüche, **dadurch gekennzeichnet, dass** der Energiefilter (20) eine Vielzahl von Einzelzellen (22) aufweist, die jeweils einen Hohlraum (16) und mindestens zwei Zwischenwände (18) aufweisen.

8. Vorrichtung nach Anspruch 7, **dadurch gekennzeichnet, dass** die Einzelzellen (22) wabenartig angeordnet sind.

9. Vorrichtung nach Anspruch 7 oder 8, **dadurch gekennzeichnet, dass** bei einer Mehrzahl von Einzelzellen (22) das Verhältnis einer maximalen lateralen Ausdehnung der Einzelzelle (22) in einer Längen- oder Breitenrichtung des Energiefilters (20) zu einer Ausdehnung der Zwischenwände (18) der Einzelzelle (22) in Höhenrichtung des Energiefilters (20) zwischen 1:2 und 1:12, vorzugsweise zwischen 1:4 und 1:10 liegt.

10. Vorrichtung nach einem der vorangehenden Ansprüche, **dadurch gekennzeichnet, dass** der Energiefilter (20) eine Mehrzahl von nebeneinander angeordneten und sich über die gesamte Höhe des Energiefilters (20) erstreckenden säulenförmigen Strukturelementen (24) aufweist, wobei eine Mehrzahl der säulenförmigen Strukturelemente (24) jeweils eine Mehrzahl von in Höhenrichtung des Energiefilters (20) hintereinander angeordneten Schichtabschnitten (14) umfasst.

11. Vorrichtung nach Anspruch 10, **dadurch gekennzeichnet, dass** eine Mehrzahl der säulenförmigen Strukturelemente (24) jeweils eine Mehrzahl von Hohlräumen (16) und eine Mehrzahl von Zwischenwänden (18) umfasst.

12. Vorrichtung nach Anspruch 10, **dadurch gekennzeichnet, dass** eine Mehrzahl der säulenförmigen Strukturelemente (24) jeweils eine Vielzahl von in Höhenrichtung des Energiefilters (20) hintereinander angeordneten Einzelzellen (22) aufweist.

13. Vorrichtung nach einem der vorangehenden Ansprüche, **dadurch gekennzeichnet, dass** der Energiefilter (20) eine Mehrzahl von gefüllten Zellen (26) aufweist.

14. Vorrichtung nach einem der vorangehenden Ansprüche, **dadurch gekennzeichnet, dass** eine Mehrzahl der Zwischenwände (18) senkrecht zu den Schichten oder Schichtabschnitten (14) angeordnet ist.

15. Vorrichtung nach einem der vorangehenden Ansprüche, **dadurch gekennzeichnet, dass** eine Mehrzahl der Zwischenwände (18) schräg zu den Schichten oder Schichtabschnitten (14) angeordnet ist.

## Claims

1. A device for the implantation of ions into a substrate (12) which is constructed as a wafer, comprising:
an energy filter (20), which is microstructured for establishing a doping depth profile and/or defect depth profile in the substrate (12) brought about by the implantation, and
which has two or more layers or layer sections (14) which are disposed one after the other in the height direction of the energy filter (20),
**characterized in that**
the energy filter (20) has a plurality of cavities (16) which are respectively disposed between at least two layers or layer sections (14), wherein intermediate walls (18) delimit the cavities (16) and connect the at least two layers or layer sections (14) to each other.

2. The device as claimed in claim 1, **characterized in that** two layers (14) outwardly delimiting the energy filter (20) are substantially continuous.

3. The device as claimed in claim 1 or claim 2, **characterized in that** two layers (14) outwardly delimiting the energy filter (20) are substantially planar.

4. The device as claimed in one of the preceding claims, **characterized in that** the distance between two successive layers or layer sections (14) is between 100 nm and 5 mm, preferably between 200 nm and 50 µm.

5. The device as claimed in one of the preceding claims, **characterized in that** the thickness of a layer or a layer section (14) is between 50 nm and 5 µm, preferably between 100 nm and 3 µm.

6. The device as claimed in one of the preceding claims, **characterized in that** the thickness of an intermediate wall (18) is between 0.5 and 500 µm, preferably between 2 and 100 µm.

7. The device as claimed in one of the preceding claims, **characterized in that** the energy filter (20) has a plurality of individual cells (22), which respectively have a cavity (16) and at least two intermediate walls (18).

8. The device as claimed in claim 7, **characterized in that** the individual cells (22) are in a honeycomb arrangement.

9. The device as claimed in claim 7 or claim 8, **characterized in that**, in the case of a plurality of individual cells (22), the ratio of a maximum lateral extent of the individual cell (22) in a length or width direction of the energy filter (20) to an extent of the intermediate walls (18) of the individual cell (22) in the height direction of the energy filter (20) is between 1:2 and 1:12, preferably between 1:4 and 1:10.

10. The device as claimed in one of the preceding claims, **characterized in that** the energy filter (20) has a plurality of columnar structural elements (24) disposed next to each other and extending over the entire height of the energy filter (20), wherein a plurality of the columnar structural elements (24) respectively comprise a plurality of layer sections (14) disposed one after the other in the height direction of the energy filter (20).

11. The device as claimed in claim 10, **characterized in that** a plurality of the columnar structural elements (24) respectively comprise a plurality of cavities (16) and a plurality of intermediate walls (18).

12. The device as claimed in claim 10, **characterized in that** a plurality of the columnar structural elements (24) respectively have multiple individual cells (22) disposed one after the other in the height direction of the energy filter (20).

13. The device as claimed in one of the preceding claims, **characterized in that** the energy filter (20) has a plurality of filled cells (26).

14. The device as claimed in one of the preceding claims, **characterized in that** a plurality of the intermediate walls (18) is disposed perpendicular to the layers or layer sections (14).

15. The device as claimed in one of the preceding claims, **characterized in that** a plurality of the intermediate walls (18) is disposed obliquely to the layers or layer sections (14).

## Revendications

1. Dispositif d'implantation d'ions dans un substrat configuré comme une plaquette (12), comprenant :
un filtre énergétique (20), qui est microstructuré pour ajuster un profil de profondeur de dopage et/ou un profil de profondeur de défaut dans le substrat (12) induits par l'implantation, et
qui présente deux couches ou sections de couches (14), qui sont disposées une derrière l'autre dans la direction de hauteur du filtre énergétique (20),
**caractérisé en ce que** :
le filtre énergétique (20) comporte une pluralité de cavités (16), qui sont respectivement disposées entre au moins deux couches ou sections de couches (14), dans lequel les parois intermédiaires (18) délimitent les cavités (16) et relient les au moins deux couches ou sections de couches (14) les unes aux autres.

2. Dispositif selon la revendication 1, **caractérisé en ce que** les deux couches (14) délimitant le filtre énergétique (20) vers l'extérieur sont formées de manière quasi continue.

3. Dispositif selon la revendication 1 ou 2, **caractérisé en ce que** les deux couches (14) délimitant le filtre énergétique (20) vers l'extérieur sont constituées essentiellement de matériaux plans.

4. Dispositif selon une des revendications précédentes, **caractérisé en ce que** la distance entre deux couches ou sections de couches superposées (14) est comprise entre 100 nm et 5 mm, de préférence entre 200 nm et 50 µm.

5. Dispositif selon une des revendications précédentes, **caractérisé en ce que** l'épaisseur d'une couche ou d'une section de couche (14) est comprise entre 50 nm et 5 µm, de préférence entre 100 nm et 3 µm.

6. Dispositif selon une des revendications précédentes, **caractérisé en ce que** l'épaisseur d'une paroi intermédiaire (18) est comprise entre 0,5 et 500 µm, de préférence entre 2 et 100 µm.

7. Dispositif selon une des revendications précédentes, **caractérisé en ce que** le filtre énergétique (20) comprend une pluralité de cellules individuelles (22), qui présentent respectivement une cavité (16) et au moins deux parois intermédiaires (18).

8. Dispositif selon la revendication 7, **caractérisé en ce que** les cellules individuelles (22) sont disposées en nid d'abeilles.

9. Dispositif selon la revendication 7 ou 8, **caractérisé en ce que**, dans le cas d'une pluralité de cellules individuelles (22), le rapport entre une extension latérale maximale de la cellule individuelle (22) dans une direction de longueur ou de largeur du filtre énergétique (20) et une extension des parois intermédiaires (18) de la cellule individuelle (22) dans la direction de hauteur du filtre énergétique (20) est compris entre 1:2 et 1:12, de préférence entre 1:4 et 1:10.

10. Dispositif selon une des revendications précédentes, **caractérisé en ce que** le filtre énergétique (20) comporte une pluralité d'éléments structuraux colonnaires (24) disposés côte à côte et s'étendant sur toute la hauteur du filtre énergétique (20), dans lequel une pluralité d'éléments structuraux colonnaires (24) comprend respectivement une pluralité de sections de couche (14) disposées l'une derrière l'autre dans la direction de hauteur du filtre énergétique (20).

11. Dispositif selon la revendication 10, **caractérisé en ce qu'**une pluralité d'éléments structuraux colonnaires (24) comprend respectivement une pluralité de cavités (16) et une pluralité de parois intermédiaires (18).

12. Dispositif selon la revendication 10, **caractérisé en ce qu'**une pluralité d'éléments structuraux colonnaires (24) comprend une pluralité de cellules individuelles (22) disposées l'une derrière l'autre dans la direction de hauteur du filtre énergétique (20).

13. Dispositif selon une des revendications précédentes, **caractérisé en ce que** le filtre énergétique (20) comprend une pluralité de cellules remplies (26).

14. Dispositif selon une des revendications précédentes, **caractérisé en ce qu'**une pluralité de parois intermédiaires (18) sont disposées perpendiculairement aux couches ou sections de couche (14).

15. Dispositif selon une des revendications précédentes, **caractérisé en ce qu'**une pluralité de parois intermédiaires (18) sont disposées obliquement aux couches ou sections de couche (14).
